(19) Europäisches Patentamt
European Patent Office
Office européen des brevets

(11) **EP 3 774 434 B1**

(12) **EUROPÄISCHE PATENTSCHRIFT**

(45) Veröffentlichungstag und Bekanntmachung des Hinweises auf die Patenterteilung:
**20.09.2023  Patentblatt 2023/38**

(21) Anmeldenummer: **19712547.9**

(22) Anmeldetag: **14.03.2019**

(51) Internationale Patentklassifikation (IPC):
**B60L 3/04** *(2006.01)*    **G01R 31/00** *(2006.01)*
**H02H 3/06** *(2006.01)*    **H02J 7/00** *(2006.01)*
**B60L 58/20** *(2019.01)*

(52) Gemeinsame Patentklassifikation (CPC):
**B60L 3/04; B60L 58/20; G01R 31/52; H02H 3/06;
H02H 3/066; H02H 3/087; H02H 7/18;
H02J 7/00308; H02J 7/0031; H02J 7/0048;
H02J 7/005; H02J 7/1423;** B60L 2210/10;
Y02T 10/70; Y02T 10/72

(86) Internationale Anmeldenummer:
**PCT/EP2019/056442**

(87) Internationale Veröffentlichungsnummer:
**WO 2019/192819 (10.10.2019 Gazette 2019/41)**

(54) **VERFAHREN UND VORRICHTUNG ZUM BETREIBEN EINES KRAFTFAHRZEUGS**

METHOD AND DEVICE FOR OPERATING A VEHICLE

PROCÉDÉ ET DISPOSITIF POUR FAIRE FONCTIONNER UN VÉHICULE À MOTEUR

(84) Benannte Vertragsstaaten:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorität: **03.04.2018  DE 102018204968**

(43) Veröffentlichungstag der Anmeldung:
**17.02.2021  Patentblatt 2021/07**

(73) Patentinhaber: **Robert Bosch GmbH
70442 Stuttgart (DE)**

(72) Erfinder: **JIN, Jiahang
70806 Kornwestheim (DE)**

(56) Entgegenhaltungen:
**WO-A2-2013/106626    DE-A1-102004 057 694
DE-A1-102010 056 235    DE-A1-102011 104 224**

**Beschreibung**

Verfahren zum Betreiben eines Kraftfahrzeugs, das ein elektrisches Hochspannungsnetz und ein elektrisches Niederspannungsnetz aufweist, wobei das Hochspannungsnetz wenigstens eine Traktionsbatterie und zumindest eine elektrische Antriebsmaschine aufweist, wobei das Niederspannungsnetz eine Bordnetzbatterie aufweist, und wobei das Hochspannungsnetz auf einen elektrischen Kurzschluss überwacht und bei Erfassen eines Kurzschlusses die Traktionsbatterie von dem Hochspannungsnetz getrennt wird.

Weiterhin betrifft die Erfindung eine Vorrichtung zum Betreiben eines Kraftfahrzeugs, wie es oben stehend beschrieben wurde.

Stand der Technik

Verfahren und Vorrichtungen der Eingangs genannten Art sind aus dem Stand der Technik bekannt. So offenbaren die DE 10 2004 057694 A1 und die DE 10 2010 056235 A1 Verfahren zum Betreiben eines Kraftfahrzeugs, das ein elektrisches Hochspannungsnetz und ein elektrisches Niederspannungsnetz aufweist. WO2013/106626 A2 ist eine weitere Veröffentlichung eines solches Fahrzeugs, das zusätzlich einen DC-Booster zum Anlegen einer Prüfspannung an das Hochspannungsnetz enthält, um unterbrochene Leiter zu erkennen.

Heutige Kraftfahrzeuge, die zumindest eine elektrische Antriebsmaschine aufweisen, nutzen zwei Spannungsnetze, ein Hochspannungsnetz zum Betreiben der elektrischen Antriebsmaschine und ein Niederspannungsnetz, das das herkömmliche Bordnetz bildet und beispielsweise eine Niedervoltspannung zwischen 12 und 24 Volt bereitstellt. Die beiden Netze sind üblicherweise durch einen Gleichspannungswandler miteinander verbunden oder verbindbar, der die Netze im Normalfall galvanisch voneinander trennt und bei Bedarf Energie von dem einen Netz in das andere Netz überträgt. Insbesondere ist es dabei möglich, das Hochspannungsnetz durch Energie aus dem Niederspannungsnetz Gleichspannungswandlers zu versorgen. Diese Betriebsart wird als Boost-Betrieb bezeichnet.

Die elektrische Energie im Hochspannungsnetz wird entweder von der Traktionsbatterie und/oder der elektrischen Maschine im generatorischen Betrieb zur Verfügung gestellt. Aufgrund der Hochspannung im Hochspannungsnetz und des hohen Energieinhalts der Traktionsbatterie ist es wichtig, dass ein Kurzschluss im Hochspannungsnetz vermieden wird. Um dem Personenschutz gerecht zu werden ist es daher bekannt, das Hochspannungsnetz auf einen Kurzschluss zu überwachen, so dass es bei Erfassen eines Kurzschluss schnellstmöglich in einen sicheren Zustand verbracht werden kann. Hierzu ist beispielsweise die Traktionsbatterie elektrisch von dem Hochspannungsnetz trennbar, so dass die Traktionsbatterie bei Erfassen eines Kurzschluss von dem Hochspannungsnetz getrennt und damit die Spannungsversorgung zu dem Hochspannungsnetz unterbrochen wird. Jedoch kann es hier auch zu Fehlauslösungen kommen, bei welchen die elektrische Verbindung zwischen der Traktionsbatterie und dem Hochspannungsnetz unterbrochen wird, ohne dass tatsächlich ein Kurzschluss im Hochspannungsnetz vorliegt. Daher wird üblicherweise nach einer Kurzschlusserkennung die Traktionsbatterie wieder an das Hochspannungsnetz angeschlossen, beispielsweise nach Ablauf einer vorgebbaren Zeitspanne. Liegt erneut eine Kurzschlussmeldung vor, wird die Traktionsbatterie wieder getrennt.

Offenbarung der Erfindung

Das erfindungsgemäße Verfahren mit den Merkmalen des Anspruchs 1 hat den Vorteil, dass vor dem Wiederverbinden der Traktionsbatterie mit dem Hochspannungsnetz eine Plausibilisierung des erfassten Kurzschlusses erfolgt, so dass sichergestellt ist, dass die Traktionsbatterie nur dann wieder an das Hochspannungsnetz angeschlossen wird, wenn kein Kurzschluss vorlag und die Trennung aufgrund eines fälschlicherweise gemeldeten Kurzschluss erfolgt ist. Gleichzeitig wird sichergestellt, dass durch die Plausibilisierung ein Wiederanschließen beziehungsweise Wiederverbinden der Traktionsbatterie an das Hochspannungsnetz verhindert wird, falls der Kurzschluss tatsächlich richtig erkannt wurde. Die Erfindung sieht hierzu vor, dass zur Plausibilisierung des erfassten Kurzschluss vor einem Wiederverbinden der Traktionsbatterie mit dem Hochspannungsnetz das Hochspannungsnetz durch das Niederspannungsnetz mittels des Gleichspannungswandlers mit einem Boost-Strom beaufschlagt und eine im Hochspannungsnetz dadurch erzeugte Boost-Spannung gemessen und mit einer erwarteten Boost-Spannung verglichen wird. Ist das Hochspannungsnetz funktionsfähig, liegt also kein Kurzschluss vor, so wird die gemessene Boost-Spannung der erwarteten Boost-Spannung oder nahezu der erwarteten Boost-Spannung entsprechen. Liegt jedoch ein Kurzschluss vor, so fällt die gemessene Boost-Spannung gegenüber der erwarteten Boost-Spannung ab und ein Fehler beziehungsweise ein Kurzschluss ist erkennbar und plausibilisierbar. Durch diesen einfachen Vergleich der erwarteten Boost-Spannung mit der gemessenen Boost-Spannung ist somit die Plausibilisierung eines zuvor erfassten Kurzschluss einfach und kostengünstig möglich.

Weiterhin ist bevorzugt vorgesehen, dass der Kurzschluss bestätigt wird, wenn bei dem Vergleich die Differenz der gemessenen Boost-Spannung zu der erwarteten Boost-Spannung über einen vorgebbaren Grenzwert hinaus abweicht. Durch das Bilden der Differenz und dem Vergleich mit dem Grenzwert wird eine besonders einfache Plausibilisierung gewährleistet. Der Grenzwert wird dabei vorzugsweise in Abhängigkeit von Rahmenbedingungen, wie Umgebungstemperatur, Verlustleistungen im Gleichspannungswandler und/oder eines aktuellen Ladezustands der Bordnetzbatterie vorgegeben.

Vorzugsweise wird der Kurzschluss verneint und die Traktionsbatterie mit dem Hochspannungsnetz wieder verbunden, wenn die Differenz unterhalb des Grenzwertes liegt oder dem Grenzwert entspricht. Führt also die Plausibilisierung dazu, dass der zuvor erkannte Kurzschluss verneint wird, so wird die Traktionsbatterie wieder an das Hochspannungsnetz angeschlossen und der Normalbetrieb des Kraftfahrzeugs fortgeführt.

Weiterhin ist bevorzugt vorgesehen, dass die Plausibilisierung nur dann durchgeführt wird, wenn die im Niederspannungsnetz verfügbare Energie größer ist als eine Zwischenkreisspeicherenergie eines Zwischenkreiskondensators des Hochspannungsnetzes. Dadurch ist sichergestellt, dass der Boost-Betrieb möglich ist und ein Strom von dem Niederspannungsnetz in das Hochspannungsnetz fließen kann.

Weiterhin ist bevorzugt vorgesehen, dass die verfügbare Energie mit der Zwischenkreisspeicherenergie unter Berücksichtigung vom Wirkungsgrad des Gleichspannungswandlers und/oder einer Verlustleistung im Hochspannungsnetz verglichen wird. Hierdurch wird die Genauigkeit des Vergleichs erhöht und die Plausibilisierungsgüte verbessert.

Die erwartete Boost-Spannung kann auf unterschiedliche Art und Weise ermittelt werden. Gemäß einer ersten Ausführungsform wird die erwartete Boost-Spannung in Abhängigkeit von einer Eingangsleistung des Gleichspannungswandlers ermittelt. Die Eingangsleistung wird insbesondere durch Messen des Eingangsstroms und der Eingangsspannung des Gleichspannungswandlers auf der Niederspannungsseite berechnet. In Kenntnis der Eingangsleistung ist die erwartete Ausgangsleistung des Gleichspannungswandlers und damit die in dem Hochspannungsnetz erwartbare Boost-Spannung berechenbar.

Insbesondere wird bei der Ermittlung der erwarteten Boost-Spannung der Wirkungsgrad des Gleichspannungswandlers und/oder die Verlustleistung im Hochspannungsnetz berücksichtigt. Damit wird die Ermittlung der Boost-Spannung weiter optimiert.

Gemäß einer zweiten Ausführungsform wird die erwartete Boost-Spannung bevorzugt in Abhängigkeit von einem Längswiderstand und einem Parallelwiderstand zu dem Zwischenkreiskondensator ermittelt. Längswiderstand und Parallelwiderstand können berechnet und/oder als zusätzliche Bauelemente in dem Hochspannungsnetz vorgesehen werden. In Abhängigkeit der Widerstände der Zwischenkreisspeicherenergie ist die zu erwartende Boost-Spannung in dem Hochspannungsnetz auf einfache Art und Weise berechenbar.

Vorzugsweise wird der Boost-Strom unterbrochen, wenn die Differenz den vorgebbaren Grenzwert überschreitet. Dadurch wird vermieden, dass Bauteile im Hochspannungsnetz thermisch überlastet werden.

Die erfindungsgemäße Vorrichtung mit den Merkmalen des Anspruchs 10 zeichnet sich durch die Ausbildung als Steuergerät aus, das speziell dazu hergerichtet ist, das erfindungsgemäße Verfahren durchzuführen. Es ergeben sich dadurch die bereits genannten Vorteile.

Weitere Vorteile und bevorzugte Merkmale und Merkmalskombinationen ergeben sich insbesondere aus dem zuvor Beschriebenen sowie aus den Ansprüchen.

Im Folgenden soll die Erfindung anhand der Zeichnung näher erläutert werden. Dazu zeigen:

Figur 1     ein elektrisches System eines Kraftfahrzeugs in einer vereinfachten Darstellung,

Figur 2     eine vereinfachte Darstellung eines Ausführungsbeispiels des Gleichspannungswandlers des elektrischen Systems,

Figur 3     ein weiteres Ausführungsbeispiel des Gleichspannungswandlers in einer vereinfachten Darstellung,

Figur 4     Spannungsverläufe des Gleichspannungswandlers und

Figur 5     ein vorteilhaftes Verfahren zum Betreiben des Kraftfahrzeugs.

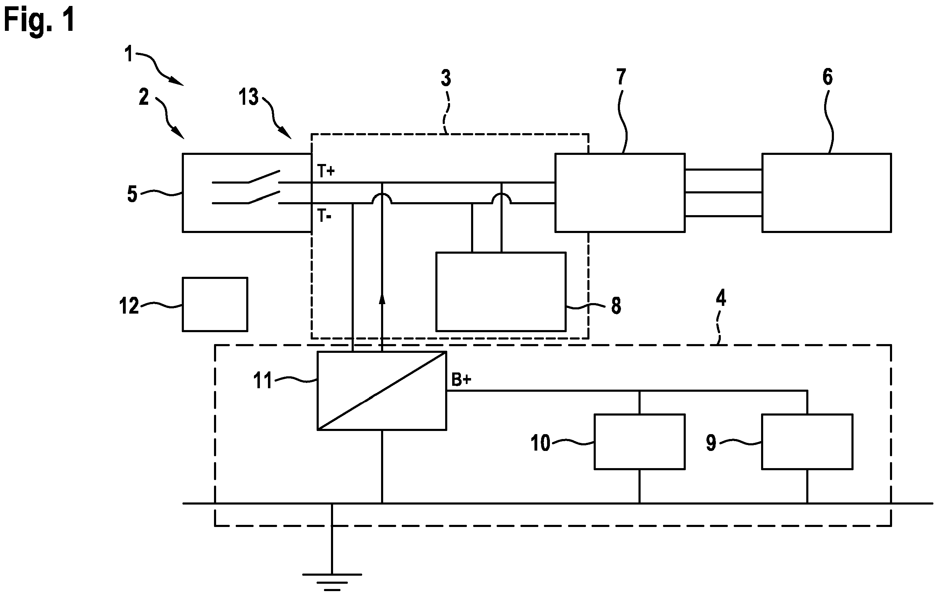

Figur 1 zeigt in einer vereinfachten Darstellung das elektrische System 1 eines hier nicht näher dargestellten Kraftfahrzeugs 2. Das System 1 weist ein Hochspannungsnetz 3 und ein Niederspannungsnetz 4 auf. Dem Hochspannungsnetz 3 sind eine Traktionsbatterie 5, eine elektrische Maschine 6, ein der elektrischen Maschine 6 vorgeschalteter Inverter 7 sowie zumindest ein Hochspannungsverbraucher 8 zugeordnet. Das Niederspannungsnetz 4 weist eine Bordnetzbatterie 9 sowie wenigstens einen Niederspannungsverbraucher 10 auf.

Die beiden Netze 3, 4 sind elektrisch durch einen ansteuerbaren Gleichspannungswandler 11 miteinander verbunden beziehungsweise verbindbar.

Weiterhin ist ein Steuergerät 12 vorhanden, das den Gleichspannungswandler 11, den Inverter 7 sowie die Verbraucher 8, 10 und eine der Hochvoltbatterie zugeordnete Schaltereinrichtung 13 betätigt. Die Schaltereinrichtung 13 ist dazu ausgebildet, bei Bedarf die Traktionsbatterie von dem Hochspannungsnetz 3 zu trennen. Dazu weist die Schalteinrichtung 13 insbesondere betätigbare Batterieschütze auf. Darüber hinaus ist das Steuergerät 12 dazu ausgebildet, eine Kurzschlussüberwachung für das Hochspannungsnetz 3 durchzuführen. Durch die Überwachung wird geprüft, ob im Hochspannungsnetz 3 ein Kurzschluss vorliegt. Ist dies der Fall, wird die Schalteinrichtung 13 betätigt und die Traktionsbatterie 5 von dem Hochspannungsnetz 3 getrennt. Dadurch wird erreicht, dass ein gegebenenfalls vorhandener Kurzschlussstrom unterbrochen und das Hochspannungsnetz 3 abgeschaltet und in einen sicheren Zustand überführt wird. Die Kurzschlusserkennungsfunktion kann jedoch auch Fehlauslösungen haben, die nicht durch einen tatsächlichen Kurzschluss im Hochspannungsnetz 3 begründet sind. Daher ist es vorteilhaft, das Hochspannungsnetz 3 nach dem Öffnen der Batterieschütze und dem Ablauf einer beispielsweise vorgebbaren Zeitdauer wieder zu starten, indem die Schalteinrichtung 13 dazu angesteuert wird, die Verbindung zwischen der Traktionsbatterie 5 und dem Hochspannungsnetz 3 wiederherzustellen. Dadurch wird die Verfügbarkeit des gesamten Systems 1 gesteigert.

Um sicherzustellen, dass die Schalteinrichtung 13 nicht aufgrund eines tatsächlich vorliegenden Kurzschlusses betätigt beziehungsweise geöffnet wurde, und das Wiederverbinden der Traktionsbatterie 5 mit dem Hochspannungsnetz nicht zu einem weiteren Kurzschluss führt, ist das im Folgenden beschriebene Verfahren vorgesehen, durch welches eine Kurzschlussprüfung beziehungsweise Plausibilisierung vor dem Wiederverbinden der Traktionsbatterie 5 mit dem Hochspannungsnetz 3 durchgeführt wird.

Dazu werden zunächst durch das Steuergerät 12 alle Verbraucher 8 und 10 deaktiviert und mittels des Gleichspannungswandlers 11 ein sogenannter Boost-Betrieb eingestellt, durch welchen das Hochspannungsnetz 3 durch das Niederspannungsnetz 4 mit Energie gespeist beziehungsweise versorgt wird.

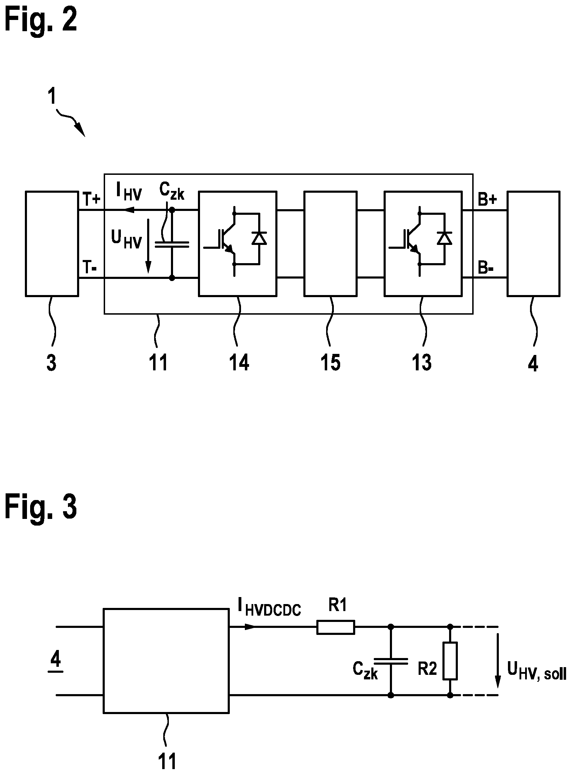

Figur 2 zeigt hierzu vereinfacht den Gleichspannungswandler 11, der zwischen dem Hochspannungsnetz 3 und dem Niederspannungsnetz 4 geschaltet ist. Der Gleichspannungswandler 11 ist als bidirektional arbeitender Gleichspannungswandler ausgebildet. Um den Boost-Vorgang durchzuführen, weist er auf der Niedervoltseite einen Gleichrichter auf und auf der Hochvoltseite einen Umrichter 14. Zwischen Gleichrichter 13 und Umrichter 14 ist ein Transformator 15 geschaltet, der das Spannungsniveau des Niederspannungsnetzes 4 auf das des Hochspannungsnetzes 3 anhebt. Parallel zu dem Umrichter 14 ist auf der Hochspannungsseite ein Zwischenkreiskondensator $C_{zk}$ geschaltet.

Zunächst wird durch das Steuergerät 12 geprüft, ob die elektrische Energie im Niederspannungsnetz 4 ausreichend ist, um das Hochspannungsnetz 3 aufzuladen. Die verfügbare elektrische Energie im Niederspannungsnetz hängt stark von dem aktuellen Ladezustand der Bordnetzbatterie 9 ab. Die Spannung im Niederspannungsnetz soll je nach Betriebszustand mindestens auf einer Spannung eingehalten werden, um die Verbraucher 10, insbesondere die sicherheitsrelevanten Verbraucher 10 zu versorgen. Daher soll die tatsächlich verfügbare elektrische Energie $E_v$ in der Bordnetzbatterie 9 für den Boost-Betrieb ermittelt werden. Unter Berücksichtigung der aktuellen Betriebstemperatur T, dem Ladezustand SOC der Bordnetzbatterie 9 (SOC = state-of-charge = Ladezustand), dem Gebrauchszustand SOH der Bordnetzbatterie 9 (SOH-Gesundheitszustand/State of Health) und der unteren Batteriespannungsschwelle $U_s$, die vom aktuellen Betriebszustand abhängig ist, ergibt sich für die verfügbare elektrische Energie:

$$E_v = f(T, SOC, SOH, U_S)$$

Eine Kurzschlussstelle ist nicht immer gut leitfähig, wenn die die Kurzschlussstelle beaufschlagende Spannung klein ist. Deshalb wird die Spannung im Hochspannungsnetz 3 soweit erhöht, dass mindestens eine normale Betriebsspannung $U_{HV,min}$ erreicht ist. Damit gilt für die im Zwischenkreis beziehungsweise Zwischenkreiskondensator $C_{zk}$ gespeicherte Energie $E_{zk,min}$:

$$E_{zk,min} = \frac{1}{2} C_{zk} U_{HV,min}{}^2$$

Unter Berücksichtigung des Wirkungsgrads n des Gleichspannungswandlers 11 und der Verlustleistung $E_{vl}$ im Hochspannungsnetz 3, die beispielsweise durch eine Selbstentladung und/oder den Entladewiderstand entsteht, soll die folgende Bedingung geprüft werden:

$$E_v > \frac{E_{zk,min}}{n} + E_{vl}$$

Wenn diese Bedingung erfüllt ist, kann der Boost-Betrieb durchgeführt werden. Entsprechend steuert das Steuergerät 12 den Gleichspannungswandler 11 dazu an, einen Boost-Strom $I_{HV}$ in das Hochspannungsnetz 3 zu treiben. Mit der vom Hochspannungsnetz 3 getrennten Traktionsbatterie 5 und den abgeschalteten Verbrauchern 8 müsste somit die Zwischenkreisspannung im Laufe des Boost-Betriebs steigen.

Es wird im Folgenden eine erwartete Boost-Spannung $U_{HV,soll}$ mit einer gemessenen Boost-Spannung $U_{HV,mess}$ verglichen. Wenn die Differenz dieser beiden einen vorgebbaren Grenzwert $U_{HV,S}$ überschreitet, wird auf eine Fehlfunktion erkannt beziehungsweise der im Hochspannungsnetz 3 vorliegende Kurzschluss bestätigt/plausibilisiert. Infolge dessen wird der Gleichspannungswandler 11 durch das Steuergerät 12 wieder deaktiviert und der Boost-Betrieb beendet. Darüber hinaus wird ein Wiederverbinden der Traktionsbatterie an das Hochspannungsnetz 3 verhindert.

Die erwartete Boost-Spannung $U_{HV,Soll}$ wird bevorzugt durch eines der zwei im Folgenden beschriebenen Verfahren ermittelt.

Für das erste Verfahren wird die Eingangsleistung $P_{DCDC,in}$ des Gleichspannungswandlers 11 im Boost-Betrieb durch Messen der Eingangsspannung des Niederspannungsnetzes $U_{lv}$ und die Messung des Eingangsstroms $I_{lv}$ ermittelt:

$$P_{DCDC,in} = U_{LV} I_{LV}$$

Unter Berücksichtigung des Wirkungsgrads n und der Verlustleistung im Hochspannungsnetz 3 ohne die Traktionsbatterie 5 $P_{vl}$ ist die Leistung für das Aufladen des Hochspannungsnetzes wie folgt zu berechnen:

$$P_{HV} = n U_{LV} - P_{vl}$$

Aus der Energiebilanz gilt dann:

$$\int_{t=t1}^{t} P_{HV} dt = \frac{1}{2} C_{ZK} U^2{}_{HV,soll}$$

Die erwartete Spannung $U_{HV,soll}$ wird durch Umstellen der zuletzt genannten Formel zu jedem Zeitpunkt berechnet.

Bei dem zweiten Verfahren wird ein vereinfachtes Schaltungsmodell aufgebaut, wie in Figur 3 gezeigt. Ein Hochspannungsstrom $I_{HVDCDC}$ sowie die Boost-Spannung $U_{HV(t=t_1)}$ zum Anfangszeitpunkt des Boost-Betriebs werden gemessen. Ein Längswiderstand R1 und Parallelwiderstand R2 werden bevorzugt geschätzt oder durch Experimente ermittelt. Der Zwischenkreiskondensator $C_{ZK}$ ist in der Schaltungsauslegung bereits berücksichtigt. Damit gilt:

$$U_{HV,soll} = U_{HVDCDC;Mod} = f(I_{HVDCDC}(t), R_1 R_2, C, U_{HV}(t = t_1))$$

Die erwartete Boost-Spannung $U_{HV,soll}$ wird mit der gemessenen Boost-Spannung $U_{HV}$ verglichen. Falls deren Differenz $U_{HV,diff}$ überschreitet, dann wird ein Kurzschluss im Hochspannungsnetz 3 festgestellt beziehungsweise plausibilisiert. In diesem Fall wird der Boost-Betrieb unterbrochen, um eine mögliche thermische Überlastung von Bauteilen im Hochspannungsnetz 3 zu vermeiden. Wie zuvor bereits erwähnt, wird auch verhindert, dass die Schalteinrichtung 13 erneut betätigt wird, um die Traktionsbatterie 5 mit dem Hochspannungsnetz 3 zu verbinden.

Falls die Differenz der erwarteten Boost-Spannung und der gemessenen Boost-Spannung im Laufe des Boost-Betriebs unterhalb des Grenzwertes $U_{HV,diff}$ verbleibt, kann das Hochspannungsnetz 3 wieder aktiviert und dazu die Schalteinrichtung 13 betätigt werden, so dass die Traktionsbatterie 5 wieder mit dem Hochspannungsnetz 3 verbunden wird.

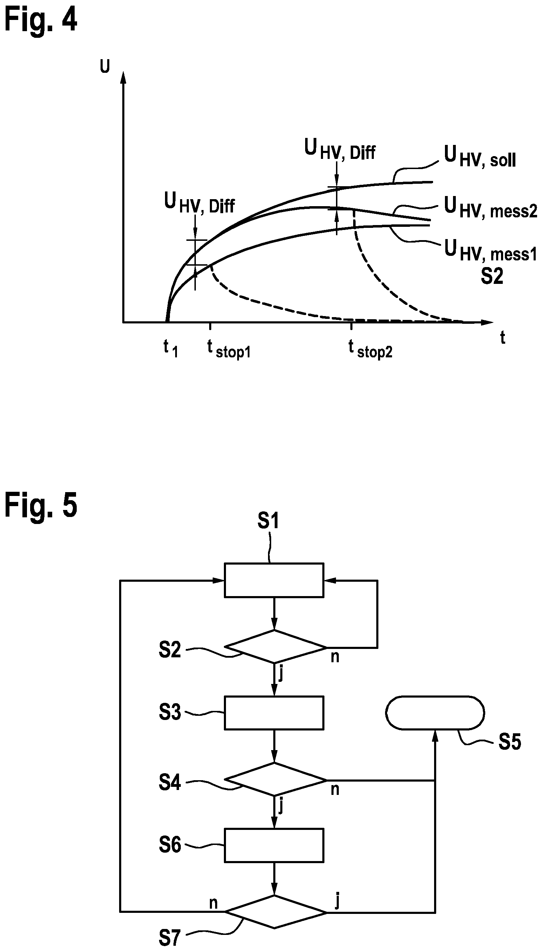

Figur 4 zeigt beispielhafte Spannungsverläufe U über die Zeit t anhand von zwei Fehlersituationen. Im ersten Fall tritt der Kurzschluss erst ab Erreichen einer bestimmten Spannung im Hochspannungsnetz 3 auf ($O_{HV,mess1}$) und im zweiten Fall lädt der Kurzschluss permanent vor ($U_{HV,mess2}$).

Figur 5 zeigt vereinfacht das oben beschriebene Verfahren noch einmal zusammengefasst. In Schritt S1 wird das System 1 in Betrieb genommen und es wird von einem Normalbetrieb ausgegangen. Im Schritt S2 wird das Hochvoltnetz 3 auf Kurzschlüsse überwacht. Liegt kein Kurzschluss vor, so wird im Schritt S1 weiter verfahren. Wird jedoch ein Kurzschluss erkannt (j), wird im darauf folgenden Schritt S3 die Schalteinrichtung 13 betätigt, um die Traktionsbatterie 5 von dem Hochspannungsnetz 3 zu trennen.

Anschließend wird in einem Schritt S4 geprüft, ob die im Niederspannungsnetz verfügbare Energie ausreicht, um das Hochspannungsnetz 3 aufzuladen. Ist dies nicht der Fall (n) wird das Hochspannungsnetz 3 in einem Schritt S5 dauerhaft deaktiviert, indem dauerhaft verhindert wird, dass die Traktionsbatterie 5 wieder mit dem Hochspannungsnetz 3 verbunden wird.

Reicht die Energie jedoch aus (j), so wird in einem Schritt S6 der Boost-Betrieb, wie zuvor erläutert, durchgeführt und in einem Schritt S7 die oben beschriebene Abfrage zur Plausibilisierung des Kurzschlusses durch einen Vergleich der erwarteten Boost-Spannung mit einer gemessenen Boost-Spannung durchgeführt. Wird dabei der Kurzschluss betätigt/plausibilisiert, so wird gemäß Schritt S5 das System 1 abgeschaltet. Wird der Kurzschluss jedoch nicht bestätigt (n), so wird im Schritt S1 weiter verfahren, indem die Schalteinrichtung 13 betätigt wird, um die Traktionsbatterie 5 mit dem Hochspannungsnetz 3 zu verbinden.

**Patentansprüche**

1. Verfahren zum Betreiben eines Kraftfahrzeugs (2), das ein elektrisches Hochspannungsnetz (3) und ein elektrisches Niederspannungsnetz (4) aufweist, wobei das Hochspannungsnetz (3) wenigstens eine Traktionsbatterie (5) und zumindest eine elektrische Antriebsmaschine (6) aufweist, wobei das Niederspannungsnetz (4) eine Bordnetzbatterie (9) aufweist, und wobei das Hochspannungsnetz (3) auf einen elektrischen Kurzschluss überwacht und bei Erfassen eines Kurzschlusses die Traktionsbatterie (5) von dem Hochspannungsnetz (3) getrennt wird, **dadurch gekennzeichnet, dass** zur Plausibilisierung des erfassten Kurzschluss vor einem Wiederverbinden der Traktionsbatterie (5) mit dem Hochspannungsnetz (3) das Hochspannungsnetz (3) durch das Niederspannungsnetz (4) mittels eines Gleichspannungswandlers (11) mit einem Boost-Strom ($I_{HV}$) beaufschlagt und eine im Hochspannungsnetz (3) gemessene Boost-Spannung ($U_{HV}$) mit einer erwarteten Boost-Spannung ($U_{HV,soll}$) verglichen wird.

2. Verfahren nach Anspruch 1, **dadurch gekennzeichnet, dass** der Kurzschluss bestätigt wird, wenn bei dem Vergleich die Differenz der gemessenen Boost-Spannung ($U_{HV}$) zu der erwarteten Boost-Spannung ($U_{HV,soll}$) über einen vorgebbaren Grenzwert hinaus abweicht.

3. Verfahren nach einem der vorhergehenden Ansprüche, **dadurch gekennzeichnet, dass** der Kurzschluss verneint und die Traktionsbatterie (5) mit dem Hochspannungsnetz (3) verbunden wird, wenn die Differenz unterhalb des Grenzwertes liegt oder dem Grenzwert entspricht.

4. Verfahren nach einem der vorhergehenden Ansprüche, **dadurch gekennzeichnet, dass** die Plausibilisierung nur dann durchgeführt wird, wenn die im Niederspannungsnetz (4) verfügbare Energie ($E_V$) größer ist als eine Zwischenkreisspeicherenergie eines Zwischenkreiskondensators ($C_{ZK}$) des Hochspannungsnetzes (3).

5. Verfahren nach einem der vorhergehenden Ansprüche, **dadurch gekennzeichnet, dass** die verfügbare Energie mit der Zwischenkreisspeicherenergie unter Berücksichtigung vom Wirkungsgrad des Gleichspannungswandlers (11) und/oder einer Verlustleistung im Hochspannungsnetz (3) verglichen wird.

6. Verfahren nach einem der vorhergehenden Ansprüche, **dadurch gekennzeichnet, dass** die erwartete Boost-Spannung ($U_{HV,soll}$) in Abhängigkeit von einer Eingangsleistung des Gleichspannungswandlers (11) ermittelt wird.

7. Verfahren nach einem der vorhergehenden Ansprüche, **dadurch gekennzeichnet, dass** bei der Ermittlung der erwarteten Boost-Spannung ($U_{HV,soll}$) der Wirkungsgrad des Gleichspannungswandlers (11) und/oder die Verlustleistung im Hochspannungsnetz (3) berücksichtigt werden.

8. Verfahren nach einem der vorhergehenden Ansprüche, **dadurch gekennzeichnet, dass** die erwartete Boost-Spannung ($U_{HV,soll}$) in Abhängigkeit von einem Längswiderstand ($R_1$) und einem Parallelwiderstand ($R_2$) zu dem Zwischenkreiskondensator ($C_{ZK}$) ermittelt wird.

9. Vorrichtung zum Betreiben eines Kraftfahrzeugs (2), das ein elektrisches Hochspannungsnetz (3) und ein elektrisches Niederspannungsnetz (4) aufweist, wobei das Hochspannungsnetz (3) wenigstens eine Traktionsbatterie (5) und zumindest eine elektrische Antriebsmaschine (6) aufweist, wobei das Niederspannungsnetz (4) eine Bordnetzbatterie (9) aufweist, und wobei das Hochspannungsnetz (3) mit dem Niederspannungsnetz (4) durch einen Gleichspannungswandler (11) verbindbar/verbunden ist, **gekennzeichnet durch** die Ausbildung als Steuergerät (12), das speziell dazu hergerichtet ist, das Verfahren nach einem der Ansprüche 1 bis 8 durchzuführen.

10. Elektrisches System (1) eines Kraftfahrzeugs (2) mit einem Hochspannungsnetz (3) für eine Traktionsbatterie (5) und einem Niederspannungsnetz (4) für eine Bordnetzbatterie (9), wobei das Hochspannungsnetz (3) mit dem Niederspannungsnetz (4) durch einen Gleichspannungswandler (11) verbindbar/verbunden ist, **gekennzeichnet durch** eine Vorrichtung nach Anspruch 9.

**Claims**

1. Method for operating a motor vehicle (2) that has an electrical high-voltage network (3) and an electrical low-voltage network (4), wherein the high-voltage network (3) has at least one traction battery (5) and at least one electric drive machine (6), wherein the low-voltage network (4) has an on-board electrical system battery (9), and wherein the high-voltage network (3) monitors for an electrical short circuit, and the traction battery (5) is isolated from the high-voltage network (3) if a short circuit is detected, **characterized in that,** in order to check the plausibility of the detected short circuit before reconnecting the traction battery (5) to the high-voltage network (3), a boost current ($I_{HV}$) is applied to the high-voltage network (3) by the low-voltage network (4) by means of a DC-DC converter (11), and a boost voltage ($U_{HV}$), which is measured in the high-voltage network (3), is compared with an expected boost voltage ($U_{HV,soll}$).

2. Method according to Claim 1, **characterized in that** the short circuit is confirmed if, during the comparison, the difference between the measured boost voltage ($U_{HV}$) and the expected boost voltage ($U_{HV,soll}$) deviates beyond a predefinable limit value.

3. Method according to either of the preceding claims, **characterized in that** the short circuit is denied and the traction battery (5) is connected to the high-voltage network (3) if the difference is below the limit value or corresponds to the limit value.

4. Method according to one of the preceding claims, **characterized in that** the plausibility check is only carried out if the energy ($E_v$) available in the low-voltage network (4) is greater than an intermediate circuit stored energy of an intermediate circuit capacitor ($C_{ZK}$) of the high-voltage network (3).

5. Method according to one of the preceding claims, **characterized in that** the available energy is compared with the intermediate circuit stored energy taking into account the efficiency of the DC-DC converter (11) and/or a power loss in the high-voltage network (3).

6. Method according to one of the preceding claims, **characterized in that** the expected boost voltage ($U_{HV,\,soll}$) is ascertained depending on an input power of the DC-DC converter (11).

7. Method according to one of the preceding claims, **characterized in that** the efficiency of the DC-DC converter (11) and/or the power loss in the high-voltage network (3) are taken into account when ascertaining the expected boost voltage ($U_{HV,soll}$).

8. Method according to one of the preceding claims, **characterized in that** the expected boost voltage ($U_{HV,\,soll}$) is ascertained depending on a resistor ($R_1$) in series with, and a resistor ($R_2$) in parallel with, the intermediate circuit capacitor ($C_{ZK}$).

9. Device for operating a motor vehicle (2) that has an electrical high-voltage network (3) and an electrical low-voltage network (4), wherein the high-voltage network (3) has at least one traction battery (5) and at least one electric drive machine (6), wherein the low-voltage network (4) has an on-board electrical system battery (9), and wherein the high-voltage network (3) is able to be connected/is connected to the low-voltage network (4) by way of a DC-DC converter (11), **characterized by** its design as a control unit (12) that is specifically set up to carry out the method according to one of Claims 1 to 8.

10. Electrical system (1) of a motor vehicle (2) with a high-voltage network (3) for a traction battery (5) and a low-voltage network (4) for an on-board electrical system battery (9), wherein the high-voltage network (3) is able to be connected/is connected to the low-voltage network (4) by way of a DC-DC converter (11), **characterized by** a device according to Claim 9.

**Revendications**

1. Procédé de fonctionnement d'un véhicule automobile (2) qui comporte un réseau électrique à haute tension (3) et un réseau électrique à basse tension (4), le réseau à haute tension (3) comportant au moins une batterie de traction (5) et au moins une machine d'entraînement électrique (6), le réseau à basse tension (4) comportant une batterie de réseau de bord (9), et le réseau à haute tension (3) étant surveillé en termes de court-circuit électrique et la batterie de traction (5) étant séparée du réseau à haute tension (3) lorsqu'un court-circuit est détecté, **caractérisé en ce que**, pour contrôler la vraisemblance du court-circuit détecté avant de reconnecter la batterie de traction (5) au réseau à haute tension (3), le réseau à haute tension (3) est soumis à un courant de suralimentation ($I_{HV}$) au moyen d'un convertisseur de tension continue (11) par le biais du réseau à basse tension (4) et une tension de suralimentation ($U_{HV}$) mesurée dans le réseau à haute tension (3) est comparée à une tension de suralimentation attendue ($U_{HV,soll}$).

2. Procédé selon la revendication 1, **caractérisé en ce que** le court-circuit est confirmé si, lors de la comparaison, la différence entre la tension de suralimentation mesurée ($U_{HV}$) et la tension de suralimentation attendue ($U_{HV,soll}$) s'écarte d'une valeur limite spécifiable.

3. Procédé selon l'une des revendications précédentes, **caractérisé en ce que** le court-circuit est annulé et la batterie de traction (5) est reliée au réseau à haute tension (3) si la différence est inférieure à la valeur limite ou correspond à la valeur limite.

4. Procédé selon l'une des revendications précédentes, **caractérisé en ce que** le contrôle de la vraisemblance n'est effectué que si l'énergie ($E_v$) disponible dans le réseau à basse tension (4) est supérieure à une énergie de stockage de circuit intermédiaire d'un condensateur de circuit intermédiaire ($C_{ZK}$) du réseau à haute tension (3).

5. Procédé selon l'une des revendications précédentes, **caractérisé en ce que** l'énergie disponible est comparée à l'énergie de stockage de circuit intermédiaire avec prise en compte du rendement du convertisseur de tension continue (11) et/ou d'une perte de puissance dans le réseau à haute tension (3).

6. Procédé selon l'une des revendications précédentes, **caractérisé en ce que** la tension de suralimentation attendue ($U_{HV,soll}$) est déterminée en fonction d'une puissance d'entrée du convertisseur de tension continue (11).

7. Procédé selon l'une des revendications précédentes, **caractérisé en ce que**, lors de la détermination de la tension de suralimentation attendue ($U_{HV,soll}$), le rendement du convertisseur de tension continue (11) et/ou la perte de puissance dans le réseau à haute tension (3) sont pris en compte.

8. Procédé selon l'une des revendications précédentes, **caractérisé en ce que** la tension de suralimentation attendue ($U_{HV,soll}$) est déterminée en fonction d'une résistance série ($R_1$) et d'une résistance parallèle ($R_2$) au condensateur de circuit intermédiaire ($C_{ZK}$) .

9. Dispositif de fonctionnement d'un véhicule automobile (2) qui comporte un réseau électrique à haute tension (3) et un réseau électrique à basse tension (4), le réseau à haute tension (3) comportant au moins une batterie de traction (5) et au moins une machine d'entraînement électrique (6), le réseau à basse tension (4) comportant une batterie de réseau de bord (9), et le réseau à haute tension (3) étant ou pouvant être relié au réseau à basse tension (4) par le biais d'un convertisseur de tension continue (11), **caractérisé en ce qu'**il est conçu comme un appareil de commande (12) qui est spécialement conçu pour mettre en œuvre le procédé selon l'une des revendications 1 à 8.

10. Système électrique (1) d'un véhicule automobile (2) comprenant un réseau à haute tension (3) destiné à une batterie de traction (5) et un réseau à basse tension (4) destiné à une batterie de réseau de bord (9), le réseau à haute tension (3) étant ou pouvant être relié au réseau à basse tension (4) par le biais d'un convertisseur de tension continue (11), **caractérisé par** un dispositif selon la revendication 9.

# Fig. 1

EP 3 774 434 B1

# Fig. 2

# Fig. 3

# Fig. 4

# Fig. 5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102004057694 A1
- DE 102010056235 A1
- WO 2013106626 A2